(19) Europäisches Patentamt
European Patent Office
Office européen des brevets

(11) Veröffentlichungsnummer: **0 216 083**
**B1**

(12) # EUROPÄISCHE PATENTSCHRIFT

(45) Veröffentlichungstag der Patentschrift: **27.12.90**

(51) Int. Cl.[5]: **C08F 8/28**

(21) Anmeldenummer: **86110604.5**

(22) Anmeldetag: **31.07.86**

(54) **Polyvinylacetal und dieses enthaltendes lichtempfindliches Gemisch.**

(30) Priorität: **02.08.85 US 762089**
**02.08.85 US 762078**
**02.08.85 US 762079**
**02.08.85 US 762087**

(43) Veröffentlichungstag der Anmeldung:
**01.04.87 Patentblatt 87/14**

(45) Bekanntmachung des Hinweises auf die Patenterteilung:
**27.12.90 Patentblatt 90/52**

(84) Benannte Vertragsstaaten:
**DE FR GB**

(56) Entgegenhaltungen:
**DE-C- 755 027**
**FR-A- 2 152 884**
**GB-A- 1 342 289**
**GB-A- 1 567 280**

**Kl. Weissermel, H.-J. Arpe: Industrielle Organische Chemie, Verlag Chemie, 1976**
**Wacker Firmenschrift: Rohstoffe für Lacke, Anstrichmittel und Klebestoffe, März 1972**

**Die Akte enthält technische Angaben, die nach dem Eingang der Anmeldung eingereicht wurden und die nicht in dieser Patentschrift enthalten sind.**

(73) Patentinhaber: **HOECHST CELANESE CORPORATION, Route 202-206 North, Somerville, N.J. 08876(US)**

(72) Erfinder: **Walls, John E., Dipl.-Chem., 19 Bowlby Street, Hampton, NJ 08801(US)**
Erfinder: **Dhillon, Major S., Dipl.-Chem., 896C Merrit Dr., Hillsborough, NJ 08876(US)**
Erfinder: **Duyal, Tulay, Dipl.-Chem., 15 Alexandria Drive, Manalapan, NJ 07726(US)**
Erfinder: **Koletar, Gabor I., Dipl.-Chem., 212, Dogwood Lane, Berkeley Heights, NJ 07922(US)**
Erfinder: **Tellechea, Carlos, Dipl.-Chem., 82 East End Avenue, Shrewsbury, NJ 07701(US)**

(74) Vertreter: **Neubauer, Hans-Joachim et al, KALLE Niederlassung der Hoechst AG Patentabteilung Postfach 3540 Rheingaustrasse 190, D-6200 Wiesbaden1(DE)**

**EP 0 216 083 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die vorliegende Erfindung betrifft ein Polymeres, das geeignet ist für die Herstellung lichtempfindlicher Materialien, die in wäßrigen Entwicklern entwickelbar sind, sowie ein lichtempfindliches Gemisch zur Herstellung lichtempfindlicher Materialien, wie z. B. Flachdruckplatten.

Die Druckplatten zeichnen sich durch eine größere Stabilität und Auflagenhöhe aus und sind ohne den Zusatz organischer Lösemittel entwickelbar. Das Gemisch läßt sich leicht zu Schichten mit guten Hafteigenschaften verarbeiten, die insbesondere für die Herstellung von Flachdruckplatten geeignet sind.

Es sind zahlreiche Polymere bekannt, die allgemein für die Herstellung von lichtempfindlichen Materialien geeignet sind. Die Einsatzmöglichkeiten der meisten dieser Harze sind jedoch eingeschränkt, da zum Entwickeln der mit ihnen hergestellten lichtempfindlichen Materialien beträchtliche Mengen organischer Lösemittel benötigt werden. Derartige Entwickler sind jedoch unerwünscht, da ihre Abwässer und Dämpfe toxisch und umweltschädlich und die Lösemittel teuer sind.

Mischpolymere aus Vinylacetat, Vinylacetal und Vinylalkohol, sind aus der US-A 2 179 051 bekannt. Bei Verwendung dieser Harze zur Herstellung von lichtempfindlichen Materialien werden zum Entwickeln Entwickler mit einem Gehalt an organischen Lösemitteln benötigt.

Es ist Aufgabe der vorliegenden Erfindung, ein Harz vorzuschlagen, das zur Herstellung eines lichtempfindlichen Materials geeignet ist, für dessen Entwicklung eine Lösung verwendet werden kann, die keine organischen Lösemittel und nur geringe Mengen an Salzen und Netzmitteln enthält.

Das Harz sollte eine gute Entwicklerlöslichkeit der lichtempfindlichen Schicht gewährleisten, wobei eine Wiederablagerung von dispergierten Schichtteilen auf der Oberfläche des lichtempfindlichen Materials ausgeschlossen wird. Das Harz sollte ferner die Herstellung eines lichtempfindlichen Materials ermöglichen, das sich durch hohe Lichtempfindlichkeit, Bildauflösung und Druckauflage auszeichnet und das außerdem mit den übrigen Lösungen verträglich ist, die normalerweise bei der Herstellung und bei der Verarbeitung von Druckplatten verwendet werden.

Gegenstand der Erfindung ist ein als Bindemittel für lichtempfindliche Materialien geeignetes Polymeres aus Einheiten der Typen A, B und C, wobei A in einem Mengenanteil von 5 bis 20 Gew.-% vorliegt und der Formel

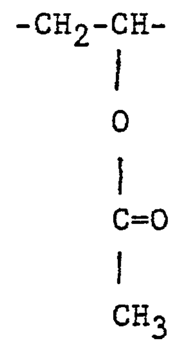

entspricht, B in einem Mengenanteil von 4 bis 30 Gew.-% vorliegt und der Formel

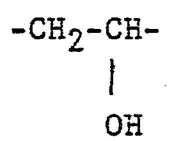

entspricht und C in einem Mengenanteil von 50 bis 91 Gew.-% vorliegt.

Das erfindungsgemäße Polymere ist dadurch gekennzeichnet, daß die Einheiten C aus Einheiten der Formel C I, C II und C III

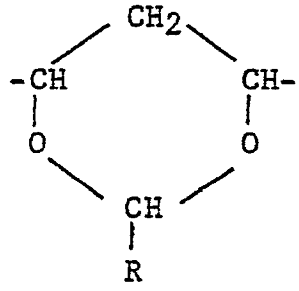 (C I), 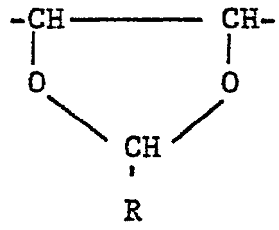 (C II), 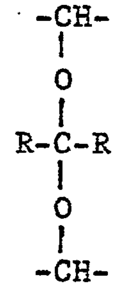 (C III)

bestehen, worin
R ein Wasserstoffatom oder eine niedere Alkylgruppe ist
und worin die Einheiten C I in einem Anteil von 75 bis 85 Gew.-%, die Einheiten C II in einem Anteil von 3 bis 5 Gew.-% und die Einheiten C III in einem Anteil von 10 bis 22 Gew.-%, bezogen auf das Gesamtgewicht der Einheiten C, vorliegen.

Erfindungsgemäß wird ferner ein Verfahren zur Herstellung des vorstehend definierten Polymeren vorgeschlagen, das dadurch gekennzeichnet ist, daß man

a) ein Vinylalkohol/Vinylacetat-Copolymeres mit einem Gehalt von 75 bis 80 Gew.-% Vinylalkoholeinheiten in einem Gemisch von Wasser und einem Hydroxylgruppen enthaltenden organischen Lösemittel auflöst,
b) die Lösung auf eine Temperatur zwischen 50° C und ihrem Siedepunkt erwärmt und eine katalytische Menge einer organischen Sulfonsäure oder einer Mineralsäure zusetzt und
c) einen niederen aliphatischen Aldehyd in solcher Menge zusetzt, daß 50 bis 91 Gew.-% der Hydroxylgruppen acetalisiert werden.

Gegenstand der Erfindung ist außerdem ein lichtempfindliches Gemisch, das als Bindemittel ein Polymeres der vorstehend angegebenen Zusammensetzung und als lichtempfindliche Verbindung ein Diazoniumsalz-Polykondensationsprodukt enthält.

Im Rahmen der vorliegenden Erfindung bezeichnet der Ausdruck "niedere Alkylgruppe" einen gesättigten gerad- oder verzweigtkettigen Kohlenwasserstoffrest mit 1 bis 8 Kohlenstoffatomen.

Die Vinylalkohol/Vinylacetatcopolymeren, die bei der Herstellung der erfindungsgemäßen Polymeren als Ausgangsmaterial geeignet sind, sind zu 75 bis 80 Gew.-% hydrolysiert und haben ein durchschnittliches Molekulargewicht ($\overline{M}$) von 5.000 bis 100.000. In dieser Beschreibung wird der hydrolysierte Anteil in Gewichtsprozent und nicht in Molprozent angegeben. Geeignete Copolymere können mittels bekannter Syntheseverfahren leicht hergestellt werden, bzw. sind im Handel erhältlich. Dazu gehören beispielsweise Vinol 523 ($\overline{M}$ = 72.000) und Vinol 205 ($\overline{M}$ = 26.000), Hersteller Air Products Co., Allentown, Pennsylvania; Elvanol 52-22 ($\overline{M}$ = 72.000), Hersteller Du Pont, Wilmington, Delaware; und Gelvatol 20-60 ($\overline{M}$ = 60.000) und Gelvatol 20-90 ($\overline{M}$ = 90.000), Hersteller Monsanto Co., St. Louis, Missouri.

Die Auswahl des als Ausgangsmaterial jeweils eingesetzten Copolymeren hängt von der späteren Verwendung des erfindungsgemäßen Polymeren ab. Wenn das Polymere beispielsweise zur Herstellung von Flachdruckplatten dient, werden bevorzugt Copolymere mit höheren Molekulargewichten (etwa 50.000 bis 100.000) gewählt. Soll das Polymere bei der Herstellung von Siebdruckschablonen verwendet werden, werden bevorzugt Copolymere mit niedrigeren Molekulargewichten (etwa 5.000 bis 30.000) eingesetzt. Diese bevorzugten Bereiche müssen jedoch nicht zwingend eingehalten werden.

Zur Herstellung des erfindungsgemäßen Polymeren wird das Copolymere zunächst in einem Gemisch aus Wasser und einem hydroxylgruppenhaltigen Lösemittel gelöst. Das hydroxylgruppenhaltige Lösemittel muß mit Wasser mischbar und sowohl für das Copolymere als auch für das als Endprodukt erhaltene Polymere als Lösemittel geeignet sein. Bevorzugt ist das hydroxylgruppenhaltige Lösemittel ein aliphatischer Alkohol, der insbesondere 1 bis 4 C-Atome besitzt, z. B. Ethanol.

In einem ersten Verfahrensschritt wird durch Lösen des Vinylalkohol/Vinylacetat-Copolymeren in einem Lösemittelgemisch aus Wasser und einem hydroxylgruppenhaltigen Lösemittel eine Reaktionslösung hergestellt. Dieser Schritt wird üblicherweise über eine Zeitdauer von mindestens 12 Stunden durchgeführt bei einer Temperatur, die je nach dem Molekulargewicht des Copolymeren zwischen 20° C und dem Siedepunkt der Lösung liegt. Anschließend wird die Temperatur der Lösung auf mindestens 50° C eingestellt, und es wird eine katalytisch wirkende Menge, bevorzugt etwa 1,0 bis 1,5 Gew.-%, einer Säure zugegeben. Diese Menge reicht nicht zur Hydrolyse aus. Innerhalb eines Zeitraums von mehreren Stunden wird dem mit der Säure versetzten Gemisch langsam ein aliphatischer Aldehyd beigemischt. Die Menge des Aldehyds wird so gewählt, daß der Acetalisierungsgrad zwischen 50 und 91 Gew.-% liegt.

Das Reaktionsgemisch wird bevorzugt während aller vorstehend beschriebener Verfahrensstufen kräftig gerührt. Vorzugsweise wird die Säure anschließend verdampft oder das Gemisch neutral gestellt.

Als Aldehyd wird Acetaldehyd oder Propionaldehyd bevorzugt. Die Wahl des jeweiligen Aldehyds hängt auch vom Verwendungszweck des erfindungsgemäßen Harzes ab. Für die Herstellung von Flachdruckplatten wird Propionaldehyd bevorzugt, während für die Herstellung einer Siebdruckschablone Acetaldehyd bevorzugt wird. Die Menge des zugesetzten Aldehyds beträgt vorzugsweise 25 bis 100 Gew.-%, insbesondere 28 bis 67 Gew.-%, jeweils bezogen auf das Gewicht des Copolymeren.

Da die Bildung der Acetalgruppen auf Kosten des Hydroxylgruppengehalts des Copolymeren erfolgt, nimmt die Wasserlöslichkeit ab. Um eine vorzeitige Ausfällung des Reaktionsproduktes zu verhindern, wird zusammen mit dem Aldehyd eine zusätzliche Menge des in dem Lösemittelgemisch enthaltenen hydroxylgruppenhaltigen Lösemittels zudosiert und so die abnehmende Wasserlöslichkeit und zunehmende Lösemittellöslichkeit des Produktes ausgeglichen.

Für eine Bildung der Acetalgruppen muß während der Aldehydzugabe eine katalytische Menge einer Säure anwesend sein. Dabei handelt es sich bevorzugt um eine Mineralsäure, wie z. B. Salzsäure, Schwefelsäure oder Phosphorsäure, oder um eine organische Sulfonsäure, z. B. p-Toluolsulfonsäure oder Stilbendisulfonsäure. Salzsäure wird besonders bevorzugt.

Nach Beendigung der Zugabe wird das Reaktionsgemisch bevorzugt neutral gestellt; dies geschieht durch Zugabe eines alkalischen Salzes, wodurch eine mögliche Deacetalisierung vermieden wird. Durch die Neutralisation wird der pH-Wert des Reaktionsgemischs auf 6,5 bis 7,5, bevorzugt auf 7,0 eingestellt. Geeignete alkalische Salze sind beispielsweise Natrium- und Kaliumcarbonat, wobei Natriumcarbonat besonders bevorzugt wird. Auch Natrium- und Kaliumhydroxid sind geeignet.

Im Anschluß an die Neutralisation wird das Reaktionsgemisch bevorzugt, jedoch nicht zwingend, auf Raumtemperatur (22-25° C) abgekühlt und danach langsam mit Wasser oder einem anderen geeigneten Mittel, wie Aceton oder Methylethylketon, versetzt. Dabei wird das Gemisch weiterhin stark gerührt, um die Ausfällung des Reaktionsproduktes zu bewirken. Das ausgefällte Produkt wird mit Wasser gewaschen, um die Reste an Säure, Aldehyd und nicht umgesetztem Copolymeren zu entfernen, und wird anschließend mit Warmluft getrocknet, bis der Wasseranteil maximal 1 % beträgt.

Wird das so erhaltene Polymere zur Herstellung eines lichtempfindlichen Materials verwendet, kann mit einer Entwicklerlösung entwickelt werden, die keine organischen Lösemittel zu enthalten braucht und in der gebebenenfalls nur geringe Mengen an Salzen und Netzmitteln enthalten sein müssen. Das erfindungsgemäße Harz gewährleistet eine gute Entwicklerlöslichkeit der lichtempfindlichen Schicht des lichtempfindlichen Materials; dabei ist eine die Verwendbarkeit des Materials einschränkende Wiederablagerung dispergierter Schichtteile auf der Oberfläche des lichtempfindlichen Materials praktisch ausgeschlossen. Die mit dem erfindungsgemäßen Polymeren hergestellten Druckplatten zeichnen sich durch sehr hohe Lichtempfindlichkeit, Bildauflösung und Druckauflage aus und weisen sowohl nach der Belichtung als auch nach der Entwicklung einen ausgezeichneten Bildkontrast auf. Außerdem ist das Polymere mit den Lösungen verträglich, die üblicherweise bei der Herstellung und Verarbeitung von Druckplatten verwendet werden.

Ein unter Verwendung des erfindungsgemäßen Polymeren hergestelltes lichtempfindliches Gemisch enthält z. B. ein Diazoniumsalz und gegebenenfalls ein photopolymerisierbares Monomeres, und einen Photoinitiator. Zur Herstellung wird gewöhnlich ein Lösemittelgemisch eingesetzt, das mit allen Bestandteilen des lichtempfindlichen Gemisches verträglich ist. Als Beispiele für geeignete Lösemittel seien Wasser, Tetrahydrofuran, Butyrolacton, Glykolether, wie Propylenglykolmonomethylether und Ethylenglykolmonomethylether, Alkohole, wie Ethanol und n-Propanol, und Ketone, wie Methylethylketon, sowie Mischungen der aufgeführten Lösemittel genannt. Bevorzugt wird als Lösemittel ein Gemisch aus Tetrahydrofuran, Propylenglykolmonomethylether und Butyrolacton verwendet. Das fertige Gemisch wird auf den Schichtträger aufgetragen, und das Lösemittel wird verdampft.

Das lichtempfindliche Gemisch kann auch noch andere bekannte Betandteile enthalten, wie z. B. Farbmittel, stabilisierende Säuren, Weichmacher und Belichtungsindikatoren.

Zu den bereits erwähnten, erfindungsgemäß einsetzbaren, lichtempfindlichen Diazoniumverbindungen gehören alle bekannten geeigneten lichtempfindlichen polymeren oder monomeren Diazoniumverbindungen, wobei die polymeren Diazoniumverbindungen bevorzugt werden. Geeignete Diazoniumverbindungen sind zum Beispiel die Formaldehydkondensationsprodukte nach US-A 2 063 631 und 2 667 415, die Polykondensationsprodukte nach US-A 3 849 392 und 3 867 147, sowie die hochlichtempfindlichen und co-kondensierten Verbindungen nach US-A 4 436 804 und 4 533 620.

Der Anteil des polymeren Bindemittels am lichtempfindlichen Gemisch beträgt vorzugsweise 20 bis 75 Gew.-%, insbesondere 30 bis 65 Gew.-%, und ganz besonders bevorzugt 35 bis 50 Gew.-%, jeweils bezogen auf den Feststoffgehalt des Gemischs.

Ein bevorzugtes lichtempfindliches Diazoniumsalz-Polykondensationsprodukt wird erhalten durch Umsetzen mindestens einer Verbindung des Typs $A\text{-}N_2X$ mit mindestens einer Verbindung des Typs $B_1$ die der Formel

$$E(-CHR_a-OR_b)_m$$

entspricht, wobei

A den Rest einer Verbindung der Formel

$$(R_1\text{-}R_3\text{-})_pR_2\text{-}N_2X$$

darstellt, in der
$R_1$ eine unsubstituierte oder substituierte Phenyl- oder Naphthylgruppe,
$R_2$ eine unsubstituierte oder substituierte Phenylengruppe,
$R_3$ eine Einfachbindung oder eine der Gruppen

$-(CH_2)_q-NR_4-$,
$-O-(CH_2)_r-NR_4-$,
$-S-(CH_2)_r-NR_4-$,
$-S-CH_2-CO-NR_4-$,
$-O-R_5-O-$,
$-O-$,
$-S-$ oder
$-CO-NR_4-$

ist, wobei
q eine Zahl von 0 bis 5,
r eine Zahl von 2 bis 5,
$R_4$ Wasserstoff, eine Alkylgruppe mit 1 bis 5 Kohlenstoffatomen, eine Aralkylgruppe mit 7 bis 12 Kohlenstoffatomen oder eine Arylgruppe mit 6 bis 12 Kohlenstoffatomen,
$R_5$ eine Arylengruppe mit 6 bis 12 Kohlenstoffatomen,
X das Anion des Diazoniumsalzes,
p eine Zahl von 1 bis 3,
E der durch Abspalten von m Wasserstoffatomen aus einem von Diazoniumgruppen freien aromatischen Amin, Phenol, Thiophenol, Phenolether, aromatischen Thioether, einer aromatischen heterocyclischen Verbindung, einem aromatischen Kohlenwasserstoff oder einem organischen Säureamid entstandene Rest,
$R_a$ ein Wasserstoffatom oder eine Phenylgruppe,
$R_b$ ein Wasserstoffatom, eine niedere Alkyl-, Acyl- oder eine Phenylgruppe und
m eine Zahl von 1 bis 10 ist,

Die Umsetzung erfolgt in einem stark sauren Kondensationsmedium, wobei die Kondensationsbedingungen so gewählt sind, daß ein Polykondensationsprodukt einer aromatischen Diazoniumverbindung erhalten wird, das im Durchschnitt 0,1 bis 50 Einheiten des Typs $B_1$ pro Einheit des Typs $A-N_2X$ enthält.

Die Diazoniumsalzkomponente besteht vorzugsweise aus dem im Mischungsverhältnis 1:1 hergestellten Polykondensationsprodukt aus 3-Methoxydiphenylamin-4-diazoniumsulfat und 4,4'-Bis-methoxymethyl-diphenylether, ausgefällt als Mesitylensulfonat nach der Lehre der US-A 3 849 392.

Das Diazoniumsalz ist in dem erfindungsgemäßen Gemisch bevorzugt in einer Menge von 3 bis 20 Gew.-%, insbesondere von 5 bis 18 Gew.-%, und besonders bevorzugt von 10 bis 15 Gew.-% enthalten, jeweils bezogen auf den Feststoffanteil des Gemischs.

In einer besonderen Ausführungsform enthält das lichtempfindliche Gemisch ferner ein polymerisierbares Monomeres. Bei Verwendung eines derartigen photopolymerisierbaren Gemischs wird gewöhnlich auch ein geeigneter Photoinitiator eingesetzt.

Als Photoinitiatoren eignen sich erfindungsgemäß bevorzugt radikalische Photoinitiatoren mit einem Absorptionsbereich von 320 bis 400 nm, z. B. Acetophenone, Benzophenone, Triazine, Benzoine, Benzoinether, Xanthone, Thioxanthone, Acridine und Benzochinone, wobei die 2-Aryl-4,6-bis-trichlormethyl-triazine besonders bevorzugt werden. Ein ganz besonders gut geeigneter Photoinitiator ist 2-Stilbenyl-4,6-bis-(trichlormethyl)-triazin.

Der Anteil des Photoinitiators am lichtempfindlichen Gemisch beträgt bevorzugt 1,5 bis über 8 Gew.-%, insbesondere 2,0 bis 6,0 Gew.-%, und ganz besonders bevorzugt 3,0 bis 4,0 Gew.-%, jeweils bezogen auf den Feststoffgehalt des Gemischs.

In besonderer Ausführungsform enthält das erfindungsgemäße Gemisch ein polyfunktionelles Acrylmonomeres mit zwei oder mehr ungesättigten Gruppen und ein Urethangruppen enthaltendes Oligomeres.

Das polyfunktionelle Acrylmonomere ist bevorzugt ein Acryl- oder Methacrylsäureester. Es kann in fester oder flüssiger Form vorliegen und hat vorzugsweise eine Viskosität von mehr als 700 mPa•s bei 25° C, insbesondere von mehr als 2000 mPa•s bei 25° C und besonders bevorzugt von mehr als 4000 mPa•s bei 25° C.

Zu den Verbindungen, die als Monomere geeignet sind, zählen beispielsweise Trimethylolpropantriacrylat und -methacrylat und deren ethoxylierte oder propoxylierte Derivate, Pentaerythrittriacrylat und -methacrylat, Dipentaerythritmonohydroxypentaacrylat und -methacrylat, Dipentaerythrithexaacrylat und -methacrylat, sowie Pentaerythrittetracrylat und -methacrylat. Bevorzugt wird Dipentaerythritmonohydroxypentaacrylat eingesetzt, doch kann auch eine Kombination verschiedener geeigneter Monomerer mit Vorteil eingesetzt werden.

Der Anteil des Monomeren beträgt bevorzugt 10 bis 35 Gew.-%, insbesondere 15 bis 30 Gew.-%, und

ganz besonders bevorzugt 15 bis 25 Gew.-%, jeweils bezogen auf den Feststoffgehalt des erfindungsgemäßen Gemischs.

Bei der oligomeren Komponente des erfindungsgemäßen photopolymerisierbaren Gemischs handelt es sich um ein lichthärtbares Oligomeres bzw. Polymeres, das erhalten wird, indem man zunächst ein mol einer im wesentlichen linearen polymeren Verbindung, die an jedem Ende ein aktives Wasserstoffatom trägt, mit mindestens zwei mol einer Diisocyanatverbindung umsetzt, so daß ein Präpolymeres entsteht, das an beiden Enden einen Isocyanatrest trägt. Anschließend wird das Präpolymere mit mindestens zwei mol einer ethylenisch ungesättigten Verbindung mit einem aktiven Wasserstoffatom umgesetzt, so daß das Präpolymere an beiden Enden einen ungesättigten Rest erhält. Bevorzugt besitzt das Oligomere ein Polyestergerüst aus einer aliphatischen Dicarbonsäure und einem aliphatischen Diol. Bevorzugt wird eine lineare Dicarbonsäure mit 2 bis 8 Kohlenstoffatomen verwendet. Als Polyester wird eine symmetrische Verbindung mit endständigen Hydroxygruppen verwendet. Herstellungsverfahren für Verbindungen dieses Typs sind bekannt und beispielsweise von Sandler und Karo in "Polymer Synthesis", Bd. 2, Academic Press, 1977, S. 140-167, beschrieben. Das Polyesterpolyol wird sodann bevorzugt mit einem aliphatischen Diisocyanat mit 2 bis 15 C-Atomen, insbesondere mit einem cycloaliphatischen Diisocyanat, umgesetzt, und zwar derart, daß eine der beiden Isocyanatgruppen mit der endständigen Hydroxygruppe des Polyestergerüsts reagiert. Die andere Isocyanatgruppe wird anschließend mit einem Hydroxygruppen enthaltenden Acryl- oder Methacrylsäureester umgesetzt. Beispielsweise wird 1,6-Hexandiol mit Adipinsäure zu einem Polyester umgesetzt, wobei das Molverhältnis größer als 1:1 ist, und der Polyester anschließend mit Dicyclohexylmethan-4,4'-bis-diisocyanat zur Reaktion gebracht, wobei das Molverhältnis von Diisocyanat zu Polyester 2:1 beträgt. Das erhaltene Produkt wird mit 2-Hydroxyethylacrylat zu einem ungesättigten Oligomeren umgesetzt, wobei das Molverhältnis von Acrylat zu dem Diisocyanat-Polyester-Reaktionsprodukt 2:1 beträgt.

Das Oligomere kann anhand der folgenden Formel dargestellt werden:

$$U\text{-}D\text{-}R'\text{-}D\text{-}U,$$

in der

R' der Rest einer im wesentlichen linearen polymeren Verbindung ist, die 2 Endgruppen mit einem aktiven Wasserstoffatom besitzt,

D der Rest einer Diisocyanatverbindung ist und

U der Rest einer ethylenisch ungesättigten Verbindung mit einem aktiven Wasserstoff ist.

Verbindungen, die als R'-Gruppen geeignet sind, sind z. B. Polyester mit endständigen Hydroxylgruppen; Polyether, die durch Umsetzung eines Diols mit einem Alkylenoxid erhalten werden, wobei das Molverhältnis von Diol zu Alkylenoxid größer als 1:1 sein muß, damit ein symmetrisches Polymeres mit endständigen Hydroxylgruppen erhalten wird; und Epoxide, die durch Umsetzung einer symmetrischen Diglycidylverbindung mit einem Diol erhalten werden, wobei das Molverhältnis von Diol zu Diglycidylverbindung größer als 1:1 sein muß, damit ein symmetrisches Polymeres mit endständigen Hydroxylgruppen erhalten wird.

Geeignete Polyester werden zum Beispiel aus den Dicarbonsäuren Oxal-, Malon-, Bernstein-, Glutar-, Adipin-, Pimelin-, Kork-, Azelain- oder Sebacinsäure und den Diolen Ethylen-, Diethylen-, Neopentyl-, Propylen- und Dipropylenglykol, 1,3-Butandiol, 1,4-Butandiol, 1,6-Hexandiol oder 2-Ethyl-1,6-hexandiol hergestellt.

Geeignete Polyether werden zum Beispiel aus den obengenannten Diolen und Ethylenoxid, Propylenoxid oder Tetrahydrofuran hergestellt.

Geeignete Epoxide werden zum Beispiel aus den obengenannten Diolen und Diglycidylisophthalat, Diglycidylterephthalat, Diglycidylphthalat oder Bisphenol-A-diglycidylether hergestellt.

Geeignete Diisocyanate sind z. B. Ethylendiisocyanat, Propylendiisocyanat, Tetramethylendiisocyanat, Dicyclohexylmethan-4,4'-diisocyanat, Hexamethylendiisocyanat, 1-Methyl-2,3-diisocyanato-cyclohexan, 1-Methyl-2,6-diisocyanato-cyclohexan, Lysindiisocyanat, 4,4'-Ethylen-bis-(cyclohexylisocyanat) und Isophorondiisocyanat.

Geeignete ethylenisch ungesättigte Verbindungen mit aktiven Wasserstoffatomen sind z. B. Hydroxyethylacrylat und -methacrylat, Hydroxypropylacrylat und -methacrylat, 1,3-Butandiolacrylat und -methacrylat, 2,4-Butandiolacrylat, 1,4-Butandiolmethacrylat, Neopentylglycolacrylat und -methacrylat, Pentaerythrittriacrylat und -trimethacrylat, sowie die Monoacrylate und Monomethacrylate von Polyethylenglykol, Polypropylenglykol und von Copolymeren von Ethylenglykol und Propylenglykol.

Im Rahmen der vorliegenden Erfindung werden bevorzugt die Oligomeren mit einem Molekulargewicht von etwa 1500 bis 4000, insbesondere von etwa 2000 bis 3500, eingesetzt. Ganz besonders bevorzugt werden Oligomere verwendet, deren Molekulargewicht etwa 3000 beträgt. Vorteilhafterweise liegt das Oligomere in fester oder halbfester Form vor, d.h., seine Viskosität bei 25° C ist größer als etwa 480 Pa•s. Der bevorzugte Anteil des Gemischs an Oligomerem beträgt etwa 10 bis 35 Gew.-%, insbesondere etwa 15 bis 30 Gew.-%, und ganz besonders bevorzugt etwa 15 bis 25 Gew.-%, jeweils bezogen auf den Gesamtfeststoffgehalt. Eine detaillierte Beschreibung solcher Oligomerer ist in der EP-A 184 725 enthalten.

Eines der hervorstechendsten Merkmale dieser Ausführungsform der vorliegenden Erfindung besteht darin, daß dank der neuen Kombination von Photoinitiator, Diazoniumsalz und photopolymerisierbarem Gemisch weder eine Sauerstoffsperrschicht nötig ist, noch die Belichtung in einer Schutzgasatmosphäre aus Stickstoff durchgeführt werden muß. Dadurch ergeben sich die Vorteile, daß 1.) das Auftragen einer zweiten Schicht entfällt, 2.) der Brechungsindex und die Löslichkeit der Sauerstoffsperrschicht nicht mehr berücksichtigt werden müssen, 3.) es nicht mehr zu einer Beeinträchtigung der Farbannahme durch die Bildstellen aufgrund von nicht entfernten Resten der Sauerstoffsperrschicht kommt, und 4.) keine Unterstrahlungen infolge der Sperrschicht mehr befürchtet werden müssen.

Der im Gemisch gegebenenfalls enthaltene Photoaktivator sollte eine Aminverbindung sein, durch deren synergistisches Zusammenwirken mit dem radikalischen Photoinitiator die Halbwertzeit der Photoinitiatorradikale, die normalerweise bei etwa $10^{-9}$ bis $10^{-15}$ Sekunden liegt, ausgedehnt wird. Beispiele geeigneter Photoaktivatoren sind 4-Dimethylamino-benzoesäure-2-(n-butoxy)-ethylester, 2-(Dimethylamino)-aminobenzoat und acrylierte Amine. Ethyl-4-dimethylaminobenzoat wird bevorzugt. Der Anteil an Photoaktivator im erfindungsgemäßen Gemisch liegt bevorzugt bei 1 bis 4 Gew.-%.

In einer weiteren speziellen Ausführungsform enthält das erfindungsgemäße photopolymerisierbare Gemisch ein polyfunktionelles Acrylmonomeres mit mindestens zwei ungesättigten Resten und ein monofunktionelles Acrylmonomeres mit einem ungesättigten Rest.

Das polyfunktionelle Acrylmonomere wurde vorstehend bereits beschrieben.

Das monofunktionelle Monomere ist bevorzugt eine Verbindung mit einer Acryl- oder Methacrylsäureestergruppe. Es liegt bevorzugt in Form einer Flüssigkeit vor, deren Viskosität bei 25° C zwischen 1 und 25 mPa•s beträgt.

Zu den erfindungsgemäß geeigneten monofunktionellen Monomeren zählen beispielsweise Trimethylolpropanmonoacrylat und -methacrylat und deren ethoxylierte oder propoxylierte Derivate, Pentaerythritacrylat und -methacrylat, Tetrahydrofurfurylacrylat und -methacrylat, Cyclohexylacrylat und -methacrylat, n-Hexylacrylat und -methacrylat, sowie Glycidylacrylat und -methacrylat. Bevorzugt wird Pentaerythritacrylat verwendet, doch hat sich auch eine Kombination verschiedener Monomerer als vorteilhaft erwiesen.

Im photopolymerisierbaren Gemisch aus diesen beiden Monomeren sollte der Anteil des polyfunktionellen Monomeren mindestens 50 %, bevorzugt 65 bis 99 % und insbesondere 80 bis 97,5 % betragen. Den Rest des photopolymerisierbaren Gemischs bildet dann das monofunktionelle Monomere.

Der Anteil des photopolymerisierbaren Gemischs beträgt vorzugsweise 20 bis 70 Gew.-%, insbesondere 30 bis 60 Gew.-%, und besonders bevorzugt 30 bis 50 Gew.-%, jeweils bezogen auf den Gesamtfeststoffgehalt des erfindungsgemäßen Gemischs.

Einer der besonderen Vorteile dieser Ausführungsform der Erfindung besteht darin, daß durch die dreidimensional vernetzte Struktur der Polymerisationsprodukte des polyfunktionellen Monomeren eine gute Festigkeit der Bildstellen und somit ein zähes Bild erzielt wird, während durch die lineare Polymerisation des monofunktionellen Monomeren eine hohe Lichtempfindlichkeit erreicht wird.

Auch bei dieser Ausführungsform ist das Aufbringen einer Sauerstoffsperrschicht bzw. das Arbeiten in einer Stickstoffschutzgasatmosphäre nicht erforderlich.

Zu den entscheidenden Vorteilen, die die vorliegende Erfindung mit sich bringt, zählt, daß die erfindungsgemäßen lichtempfindlichen Gemische mit einem Entwickler entwickelt werden können, in dem organische Lösemittel nicht zwingend vorhanden sein müssen, und der lediglich einen geringen Anteil an Salzen und Netzmitteln benötigt. Der Einsatz organischer Lösemittel stellt einen erheblichen Kostenfaktor dar. Überdies sind die Abwässer mit diesen Lösemitteln giftig und gesundheitsschädlich.

Außerdem kann das erfindungsgemäße lichtempfindliche Gemisch noch andere Bestandteile, z. B. stabilisierende Säuren, Belichtungsindikatoren, Weichmacher, Photoaktivatoren und Farbmittel enthalten.

Erfindungsgemäß geeignete stabilisierende Säuren sind zum Beispiel Phosphor-, Citronen-, Benzoe-, m-Nitrobenzoe-, p-(p-Anilinophenylazo)-benzolsulfon-, 4,4'-Dinitro-2,2'-stilbendisulfon-, Itacon-, Wein- und p-Toluolsulfonsäure, sowie Gemische aus diesen Säuren. Phosphorsäure wird bevorzugt als stabilisierende Säure verwendet. Der Anteil der gegebenenfalls zugesetzten stabilisierenden Säure beträgt vorzugsweise etwa 0,3 bis 2,0 %, insbesondere etwa 0,75 bis 1,5 %.

Zu den geeigneten Belichtungsindikatoren zählen u. a. 4-Phenylazodiphenylamin, Eosin, Azobenzol, Calcozine, Fuchsin-Farbstoffe, Kristallviolett und Methylenblau. 4-Phenylazodiphenylamin wird bevorzugt. Der Anteil des gegebenenfalls zugesetzten Belichtungsindikators am Gemisch beträgt vorzugsweise etwa 0,001 bis 0,35 Gew.-%, insbesondere etwa 0,002 bis 0,3 Gew.-%, und ganz besonders bevorzugt etwa 0,005 bis 0,2 Gew.-%.

Das erfindungsgemäße Gemisch kann ferner einen Weichmacher enthalten. Zu den geeigneten Weichmachern zählen zum Beispiel Tributylphthalat, Triarylphosphat und, bevorzugt, Dioctylphthalat, sowie deren substituierte Derivate. Der Anteil an Weichmacher im Gemisch liegt vorzugsweise bei etwa 0,5 bis 1,25 Gew.-%, doch wird der Fachmann im Bedarfsfall auch mehr oder weniger verwenden.

Zu den geeigneten Farbmitteln zählen u. a. Rhodamin, Calcozin, Viktoriablau, Methylviolett und Pigmente wie Anthrachinon und Phthalocyanin. Im allgemeinen liegt das Farbmittel in Form einer Pigmentdispersion vor, die ein oder mehrere Pigmente und/oder Farbstoffe enthält, die in einem geeigneten Lösemittel oder Lösemittelgemisch dispergiert wurden. Der Anteil des gegebenenfalls zugesetzten Farbmittels am erfindungsgemäßen Gemisch beträgt vorzugsweise etwa 1,5 bis 4,0 Gew.-%, insbesondere etwa 1,75 bis 3,0 Gew.-%, und ganz besonders bevorzugt etwa 2,0 bis 2,75 Gew.-%; doch wird der Fachmann im Bedarfsfall auch mehr oder weniger verwenden.

Zu den Trägermaterialien, die für die Beschichtung mit dem erfindungsgemäßen Gemisch zur Herstellung von Flachdruckplatten geeignet sind, zählen beispielsweise transparente Folien, z. B. aus Polyester, Aluminium und seine Legierungen, andere Metalle, Silicium und ähnliche aus dem Stand der Technik bekannte Stoffe. Aluminium wird bevorzugt als Trägermaterial eingesetzt. Der Träger wird gegebenenfalls zunächst mit Hilfe eines üblichen Verfahrens aufgerauht und/oder geätzt und/oder anodisiert und kann außerdem zusätzlich z. B. mit Polyvinylphosphonsäure, Natriumsilikat oder anderen hydrophilierend wirkenden Mitteln behandelt werden.

Zur Herstellung von Reproduktionsmaterialien, wie z. B. Flachdruckplatten, wird ein Schichtträger auf Basis von Aluminium zunächst vorzugsweise in bekannter Weise, z. B. durch Drahtbürsten, Naßschleifen oder auf elektrochemischem Weg, z. B. in einem Salzsäureelektrolyten, aufgerauht. Die aufgerauhte Platte wird danach vorzugsweise auf bekannte Weise anodisch oxydiert, z. B. in Schwefel- oder Phosphorsäure. Die aufgerauhte und gegebenenfalls anodisch oxydierte Oberfläche wird anschließend bevorzugt noch einer hydrophilierenden Nachbehandlung unterworfen, z. B. mit Polyvinylphosphonsäure, Natriumsilikat oder dergleichen. Die Nachbehandlung erfolgt ebenfalls in bekannter Weise. Die solchermaßen vorbereitete Platte wird mit dem erfindungsgemäßen Gemisch beschichtet und anschließend getrocknet. Das Schichtgewicht beträgt vorzugsweise etwa 0,6 bis 2,5 g/m$^2$, insbesondere etwa 0,8 bis 2,0 g/m$^2$, und ganz besonders bevorzugt etwa 1,2 bis 1,5 g/m$^2$; es ist jedoch im Rahmen der vorliegenden Erfindung nicht von entscheidender Bedeutung.

Die so hergestellte Druckplatte wird bevorzugt durch eine negative Testvorlage mittels aktinischer Strahlung belichtet. Die belichtete Platte wird mit einem geeigneten wäßrigen Entwicklergemisch entwickelt, z. B. mit einem Entwickler, der eine oder mehrere der folgenden Verbindungen enthält:

a) ein Natrium-, Kalium- oder Lithiumsalz von Monooctyl-, -decyl- oder -dodecylsulfat,
b) ein Natrium-, Lithium-, Kalium- oder Ammoniummetasilikat,
c) ein Lithium-, Kalium-, Natrium- oder Ammoniumborat,
d) eine aliphatische Dicarbonsäure mit 2 bis 6 C-Atomen oder eines ihrer Natrium-, Kalium- oder Ammoniumsalze und
e) Mono-, Di- oder Trinatrium oder -kaliumphosphat.

Auch Entwickler mit einem Gehalt an Wasser und Benzoesäure oder Natrium-, Lithium- oder Kaliumbenzoaten oder deren Hydroxylgruppen tragenden Derivaten sowie die in der US-A 4 436 807 beschriebenen Entwickler sind geeignet.

Die entwickelte Platte wird üblicherweise noch mit einem Konservierungsmittel behandelt, das z. B. ein hydrophiles Polymeres, wie in kaltem Wasser lösliches Dextrin und/oder Polyvinylpyrrolidon; ein nichtionisches Netzmittel, ein Feuchtmittel, ein anorganisches Salz oder Wasser sein kann, wie aus der US-A 4 213 887 hervorgeht.

Es ist bekannt, daß die mit einer so hergestellten Platte erzielbare Druckauflage durch eine Wärmebehandlung der belichteten und entwickelten Druckplatte noch gesteigert werden kann. Dabei wird die Druckplatte zunächst mit einer Lösung behandelt, durch die eine Hydrophilieeinbuße der Bildhintergrundstellen beim Einbrennen verhindert wird. Eine hierfür geeignete Lösung wird beispielsweise in der US-A 4 355 096 beschrieben. Nach dieser vorbereitenden Behandlung wird die Platte bei einer Temperatur zwischen 180° C und der Verformungstemperatur des Trägers, bevorzugt bei etwa 240° C, behandelt. Die Dauer dieser Einbrennbehandlung ist umgekehrt proportional zur Temperatur und schwankt zwischen etwa 2 und 15 Minuten. Bei 240° C beträgt sie etwa 7 Minuten.

Beispiel 1

Bei einer Temperatur von 70° C werden im Lauf von 16 Stunden 75 g Vinol 523 (ein Vinylalkohol/Vinylacetat-Copolymeres mit einem Anteil an Vinylalkoholeinheiten von etwa 75 bis 80 Gew.-% und einem durchschnittlichen Molekulargewicht von 70.000) in einer Lösung aus 225 g Wasser und 200 g Ethanol gelöst. Anschließend werden unter starkem Rühren 10,13 g Salzsäure (37 %ig) hinzugefügt und die Temperatur auf 60° C eingestellt. 37,66 g Propionaldehyd werden langsam zu dem Reaktionsgemisch gegeben. Gleichzeitig erfolgt die langsame Zugabe von 250 g Ethanol. Anschließend wird das Gemisch durch Versetzen mit einem Natriumcarbonat/Natriumhydroxidgemisch (50:50) auf einen pH-Wert von 7,0 eingestellt. Das Reaktionsprodukt wird durch Ausfällen mit Wasser in Form eines Granulats isoliert. Es folgt eine Trocknung, in deren Verlauf der Feuchtigkeitsgehalt des Produkts auf maximal 1 % gesenkt wird. Die Ausbeute beträgt 107 g oder 96 %. Das durchschnittliche Molekulargewicht beträgt 90.000.

Das erhaltene Produkt wird mit Hilfe üblicher Analyseverfahren untersucht. Es ergibt sich folgende Zusammensetzung: 13,6 % Acetatgruppen, 9,8 % Hydroxylgruppen und 76,6 % Acetalgruppen. Von den Acetalgruppen sind 80 % Sechsringacetale, 4 % Fünfringacetale und 16 % intermolekulare Acetale.

Beispiel 2

Bei einer Temperatur von 70° C werden im Lauf von 16 Stunden 40,0 g Gelvatol 20-30 (ein Vinylalkohol/Vinylacetat-Copolymeres mit einem Anteil an Vinylalkoholeinheiten von etwa 75 bis 80 Gew.-% und

einem durchschnittlichen Molekulargewicht von 10.000) in einer Lösung aus 120 g Wasser und 120 g Ethanol gelöst. Anschließend werden unter starkem Rühren 10,13 g Salzsäure (37 %ig) hinzugefügt und die Temperatur auf 60° C eingestellt. 12,06 g Acetaldehyd werden langsam zu dem Reaktionsgemisch gegeben. Gleichzeitig erfolgt die langsame Zugabe von 120 g Ethanol. Anschließend wird das Gemisch durch Versetzen mit einem Natriumcarbonat/ Natriumhydroxidgemisch (50:50) auf einen neutralen pH-Wert von 7,0 eingestellt. Das Reaktionsprodukt wird durch Ausfällen mit Wasser in Form eines Granulats isoliert. Es folgt eine Trocknung, in deren Verlauf der Feuchtigkeitsgehalt des Produkts auf maximal 1 % gesenkt wird. Die Ausbeute beträgt 49,5 g oder 95 %. Das durchschnittliche Molekulargewicht beträgt 10.500.

Das erhaltene Produkt wird mit Hilfe üblicher Analyseverfahren untersucht. Es ergibt sich folgende Zusammensetzung: 17,0 % Acetatgruppen, 28,0 % Hydroxylgruppen und 55 % Acetalgruppen. Von den Acetalgruppen sind 80 % Sechsringacetale, 4 % Fünfringacetale und 16 % intermolekulare Acetale.

Beispiel 3

Bei einer Temperatur von 70° C werden im Lauf von 16 Stunden 40 g Gelvatol 20-30 in einer Lösung aus 120 g Wasser und 120 g Ethanol gelöst. Anschließend wird unter starkem Rühren 10,13 g Salzsäure (37 %ig) hinzugefügt und die Temperatur auf 60° C eingestellt. 27,4 g Hexanal werden langsam zu dem Reaktionsgemisch gegeben. Gleichzeitig erfolgt die langsame Zugabe von 120 g Ethanol. Anschließend wird das Gemisch durch Versetzen mit einem Natriumcarbonat/Natriumhydroxidgemisch (50:50) auf einen pH-Wert von 7,0 eingestellt. Das Reaktionsprodukt wird durch Ausfällen mit Wasser in Form eines Granulats isoliert. Es folgt eine Trocknung, in deren Verlauf der Feuchtigkeitsgehalt des Produkts auf maximal 1 % gesenkt wird. Die Ausbeute beträgt 64,9 g oder 95 %. Das durchschnittliche Molekulargewicht beträgt 11.000.

Das erhaltene Produkt wird mit Hilfe üblicher Analyseverfahren untersucht. Es ergibt sich folgende Zusammensetzung: 17,0 % Acetatgruppen, 9,0 % Hydroxylgruppen und 74,0 % Acetalgruppen. Von den Acetalgruppen sind 80 % Sechsringacetale, 4 % Fünfringacetale und 16 % intermolekulare Acetale.

Beispiel 4

Bei einer Temperatur von 70° C werden im Lauf von 16 Stunden 40 g Gelvatol 20-30 in einer Lösung aus 120 g Wasser und 120 g Ethanol gelöst. Anschließend werden unter starkem Rühren 10,13 g Salzsäure (37 %ig) hinzugefügt und die Temperatur auf 60° C eingestellt. 35,98 g Octanal werden langsam zu dem Reaktionsgemisch gegeben. Gleichzeitig erfolgt die langsame Zugabe von 120 g Ethanol. Anschließend wird das Gemisch durch Versetzen mit einem Natriumcarbonat/Natriumhydroxidgemisch (50:50) auf einen pH-Wert von 7,0 eingestellt. Das Reaktionsprodukt wird durch Ausfällen mit Wasser in Form eines Granulats isoliert. Es folgt eine Trocknung, in deren Verlauf der Feuchtigkeitsgehalt des Produkts auf maximal 1 % gesenkt wird. Die Ausbeute beträgt 72,5 g oder 95 %. Das durchschnittliche Molekulargewicht beträgt 11.200.

Das erhaltene Produkt wird mit Hilfe üblicher Analyseverfahren untersucht. Es ergibt sich folgende Zusammensetzung: 17,0 % Acetatgruppen, 10,0 % Hydroxylgruppen und 73,0 % Acetalgruppen. Von den Acetalgruppen sind 80 % Sechsringacetale, 4 % Fünfringacetale und 16 % intermolekulare Acetale.

Beispiel 5 (Vergleichsbeispiel)

Eine Probe Formvar 12/85 (Polyvinylacetalharz, Herst. Monsanto Corp., St. Louis, Missouri, USA, hergestellt nach US-A 2 179 051) wird mit Hilfe üblicher Analyseverfahren untersucht, die zu folgendem Ergebnis führen: Das Produkt hat ein durchschnittliches Molekulargewicht von 32.000 und besteht zu 23,5 % aus Acetatgruppen, zu 5,7 % aus Hydroxylgruppen und zu 70,8 % aus Acetalgruppen. Von den Acetalgruppen sind 90 bis 95 % Sechsringacetale, 0 % Fünfringacetale und 5-10 % intermolekulare Acetale.

Beispiel 6 (Vergleichsbeispiel)

Eine Probe Butvar B-90 (Polyvinylbutyralharz, Herst. Monsanto Corp., St. Louis, Missouri, USA, hergestellt nach US-A 2 915 584) wird mit Hilfe üblicher Analyseverfahren untersucht, die zu folgendem Ergebnis führen: Das Produkt hat ein durchschnittliches Molekulargewicht von 41.000 und besteht zu 1 % aus Acetatgruppen, zu 19 % aus Hydroxylgruppen und zu 80 % aus Acetalgruppen. Von den Acetalgruppen sind 90 bis 95 % Sechsringacetale, 0 % Fünfringacetale und 5-10 % intermolekulare Acetale.

Beispiel 7

Verschiedene Eigenschaften eines nach Beispiel 1 hergestellten Harzes werden mit den Eigenschaften von Formvar 12/85 (Beispiel 5) und Butvar B-90 (Beispiel 6) verglichen. Die Ergebnisse sind in der

nachstehenden Tabelle zusammengefaßt. Wenn nichts anderes angegeben ist, entsprechen die angewendeten Verfahren den ASTM-Prüfmethoden.

Tabelle

| | Meßeinheit | ASTM-Verfahren | erfindungsgemäßes Harz | Formvar 12/85 | Butvar B-90 |
|---|---|---|---|---|---|
| Zugfestigkeit | $kg/mm^2$ | D 638-58 T | 8,8 - 11,4 | 4,6 - 5,3 | 4,9 - 5,6 |
| Dehnung | % | D 638-58 T | 85 | 30 | 75 |
| Glasübergangstemperatur | ° C | D1043-51 (1) | 57 - 71 | 92 - 100 | 62 - 68 |
| Dielektrizitätskonstante | $10^3$ Ohm | D 150-59 T | 2,7 | 3,1 | 3,0 |
| | $10^6$ Ohm | D 150-59 T | 2,5 | 2,9 | 2,8 |
| Viskosität | mPa·s | (2) | 2400-3000 | 500-600 | 8000-18000 |
| spez. Gewicht | - | D 792-50 | 1,227 | 1,219 | 1,100 |

(1) Die Glasübergangstemperatur wurde nach ASTM D 1043-51 und durch Differentialthermoanalyse (DSC) bestimmt. Bei dem DSC-Verfahren liegen die Meßwerte 5 bis 8° C höher als beim ASTM-Verfahren.

(2) Die Viskosität wurde an 15 gew-%igen Lösungen in einem Toluol/Ethanol-Gemisch (60:40) bei 25° C mit einem Brookfield-Viscosimeter bestimmt.

Die Ergebnisse zeigen, daß das erfindungsgemäße Harz eine deutlich verbesserte Zugfestigkeit und Dehnfähigkeit besitzt, während Glasübergangstemperatur, Dielektrizitätskonstante und spez. Gewicht weitgehend denen der bekannten Harze entsprechen. Unterschiedliche Viskositätswerte sind nicht von Bedeutung, da sie im wesentlichen durch das Molekulargewicht bedingt sind.

Beispiel 8

Bei einer Temperatur von 70° C werden im Lauf von 16 Stunden 40 g Gelvatol 20-60 (ein Vinylalkohol/Vinylacetat-Copolymeres mit einem Anteil an Vinylalkoholeinheiten von 75-80 Gew.-% und einem durchschnittlichen Molekulargewicht von 60.000) in einer Lösung aus 120 g Wasser und 120 g Ethanol gelöst. Anschließend werden unter starkem Rühren 10,13 g Salzsäure (37 %ig) und 27,41 g Hexanal hinzugefügt; dabei wird die Temperatur auf 60° C eingestellt.

Das erhaltene Produkt wird mit Hilfe üblicher Analyseverfahren untersucht. Es ergibt sich folgende Zusammensetzung: 15,2 % Acetatgruppen, 7,6 % Hydroxylgruppen und 77,2 % Acetalgruppen. Von den Acetalgruppen sind 80 % Sechsringacetale, 4 % Fünfringacetale und 16 % intermolekulare Acetale.

Beispiel 9

Bei einer Temperatur von 70° C werden im Lauf von 16 Stunden 75 g Elvanol 52-22 (ein Vinylalkohol/Vinylacetat-Copolymeres mit einem Anteil an Vinylalkoholeinheiten von 75-80 Gew.-% und einem durchschnittlichen Molekulargewicht von 90.000) in einer Lösung aus 225 g Wasser und 200 g Ethanol gelöst. Anschließend werden unter starkem Rühren 10,13 g Salzsäure (37 %ig) und 28,62 g Acetaldehyd hinzugefügt; dabei wird die Temperatur auf 60° C eingestellt.

Das erhaltene Produkt wird mit Hilfe üblicher Analyseverfahren untersucht. Es ergibt sich folgende Zusammensetzung: 17,2 % Acetatgruppen, 13,6 % Hydroxylgruppen und 69,2 % Acetalgruppen. Von den Acetalgruppen sind 80 % Sechsringacetale, 4 % Fünfringacetale und 16 % intermolekulare Acetale.

Beispiel 10

Bei einer Temperatur von 70° C werden im Lauf von 16 Stunden 40 g Vinol 205 (ein Vinylalkohol/Vinylacetat-Copolymeres mit einem Anteil an Vinylalkoholeinheiten von 75-80 Gew.-% und einem durchschnittlichen Molekulargewicht von 26.000) in einer Lösung aus 120 g Wasser und 120 g Ethanol gelöst. Anschließend werden unter starkem Rühren 10,13 Salzsäure (37 %ig) und 20,09 g Propionaldehyd hinzugefügt; dabei wird die Temperatur auf 60° C eingestellt.

Das erhaltene Produkt wird mit Hilfe üblicher Analyseverfahren untersucht. Es ergibt sich folgende Zusammensetzung: 13,6 % Acetatgruppen, 9,8 % Hydroxylgruppen und 76,6 % Acetalgruppen. Von den Acetalgruppen sind 80 % Sechsringacetale, 4 % Fünfringacetale und 16 % intermolekulare Acetale.

Beispiel 11

Eine 20 x 63 cm große Platte aus einer für Druckzwecke geeigneten Aluminiumlegierung des Typs 1100 wird mit einer wäßrig-alkalischen Entfettungslösung entfettet und in einem Medium aus Salpetersäure und Aluminiumnitrat mit Wechselstrom von 900 Coulomb elektrochemisch aufgerauht. Die aufgerauhte Platte wird gut abgespült und in einem Schwefelsäurebad anodisch oxydiert. Die Stromstärke und Spannung wird so gewählt, daß eine Oxidschicht von 2,8 g/m² erhalten wird. Danach wird die Platte nochmals abgespült und durch eine Tauchbehandlung in einer Polyvinylphosphonsäurelösung hydrophiliert. Nach einem letzten Spülgang wird die Platte getrocknet und anschließend mit einer Lösung der folgenden Zusammensetzung schleuderbeschichtet:
4,36 Gew.-% des Bindemittels von Beispiel 1,
4,59 Gew.-% eines Polykondensationsproduktes aus 3-Methoxydiphenylamin-4-diazoniumsulfat und 4,4'-Bis-methoxymethyl-diphenylether, ausgefällt als Mesitylensulfonat,
0,23 Gew.-% Phosphorsäure,
0,09 Gew.-% 4-Phenylazodiphenylamin,
6,57 Gew.-% einer Pigmentdispersion,
74,08 Gew.-% Propylenglykolmonomethylether und
10,08 Gew.-% Butyrolacton.

Die beschichtete und getrocknete Platte wird mittels aktinischer Strahlung durch eine Negativ-Testvorlage so belichtet, daß Stufe 7 eines 21-Stufen-Stauffer-Keils voll gedeckt ist. Die Platte wird mit einem Gemisch aus
6,9 Gew.-% Natriumbenzoat,
3,0 Gew.-% Natriumoctylsulfat,
2,8 Gew.-% Trinatriumphosphat,
1,5 Gew.-% Mononatriumphosphat und
85,8 Gew.-% Wasser,
dessen pH-Wert 7,3 beträgt, entwickelt und mit einem Gemisch aus
5,52 Gew.-% Dextrin (hydrolysiertes Tapiokadextrin),
1,61 Gew.-% Natriumoctylsulfat,
1,00 Gew.-% Triton X-100 (Isooctylphenolpolyoxyethylenether; 4,5 mol Ethylenoxid),
0,05 Gew.-% 1,4-Dimethyl-6-acetoxydioxan,
2,37 Gew.-% $H_3PO_4$ und
89,45 Gew.-% Wasser
konserviert. Von der fertigen Druckplatte wird auf einer Solna-Bogenoffsetmaschine, die mit einem Dahlgren-Feuchtwerk ausgestattet ist, mit stark abreibender Druckfarbe und bei großer Belastung in der Maschine so lange gedruckt, bis die Platte unbrauchbar wird. Es werden 103.000 gute Drucke erhalten.

Beispiel 12

Eine nach den Angaben von Beispiel 11 ausgewählte und vorbehandelte Aluminiumplatte wird mit einer Lösung der folgenden Zusammensetzung schleuderbeschichtet:
3,72 Gew.-% des in Beispiel 8 beschriebenen Bindemittels,
3,72 Gew.-% des in Beispiel 11 beschriebenen Polykondensationsprodukts,
0,37 Gew.-% Phosphorsäure,
0,19 Gew.-% Farbstoff,
73,60 Gew.-% Propylenglykolmonomethylether und
18,40 Gew.-% Butyrolacton.

Die beschichtete und getrocknete Platte wird mittels aktinischer Strahlung durch eine Negativ-Testvorlage so belichtet, daß auf einem 21-Stufen-Stauffer-Keil eine vollgedeckte Stufe 7 erhalten wird und

nach den Angaben von Beispiel 11 entwickelt und konserviert. Unter den Bedingungen von Beispiel 11 werden 110.000 gute Drucke erhalten.

Beispiel 13

Eine nach den Angaben von Beispiel 11 ausgewählte und vorbehandelte Aluminiumplatte wird mit einer Lösung der folgenden Zusammensetzung schleuderbeschichtet:
4,19 Gew.-% des in Beispiel 9 beschriebenen Bindemittels,
4,41 Gew.-% des in Beispiel 11 beschriebenen Polykondensationsprodukts,
0,51 Gew.-% Phosphorsäure,
4,42 Gew.-% einer Pigmentdispersion,
0,013 Gew.-% 4-Phenylazodiphenylamin und
86,46 Gew.-% eines Lösemittelgemischs, das zu 95 % aus einem n-Propanol/Wasser-Gemisch (72:28) und zu 5 % aus Butyrolacton besteht.

Die beschichtete und getrocknete Platte wird mittels aktinischer Strahlung durch eine Negativ-Testvorlage so belichtet, daß auf einem 21-Stufen-Stauffer-Keil eine vollgedeckte Stufe 7 erhalten wird und nach den Angaben von Beispiel 11 entwickelt und konserviert. Unter den Bedingungen von Beispiel 11 werden 125.000 gute Drucke erhalten.

Beispiel 14

Eine nach den Angaben von Beispiel 11 ausgewählte und vorbehandelte Aluminiumplatte wird mit einer Lösung der folgenden Zusammensetzung schleuderbeschichtet:
8,00 Gew.-% des in Beispiel 10 beschriebenen Bindemittels,
10,00 Gew.-% des in Beispiel 11 beschriebenen Polykondensationsprodukts,
2,00 Gew.-% Phosphorsäure,
0,05 Gew.-% 4-Phenylazodiphenylamin,
9,00 Gew.-% einer Pigmentdispersion,
35,48 Gew.-% Propylenglykolmonomethylether und
35,48 Gew.-% Butyrolacton.

Die beschichtete und getrocknete Platte wird mittels aktinischer Strahlung durch eine Negativ-Testvorlage so belichtet, daß auf einem 21-Stufen-Stauffer-Keil eine vollgedeckte Stufe 7 erhalten wird und nach den Angaben von Beispiel 11 entwickelt und konserviert. Unter den Bedingungen von Beispiel 11 werden 70.000 gute Drucke erhalten.

Beispiel 15

Eine nach den Angaben von Beispiel 11 ausgewählte und vorbehandelte Aluminiumplatte wird mit einer Lösung der folgenden Zusammensetzung schleuderbeschichtet:
5,48 Gew.-% des in Beispiel 2 beschriebenen Bindemittels,
3,47 Gew.-% eines Cokondensationsprodukts aus Diphenylamin-4-diazoniumsulfat und 2,5-Dimethoxy-4-(tolylmercapto)-benzoldiazoniumtetrachlorozinkat, in Paraformaldehyd,
0,23 Gew.-% Phosphorsäure,
0,09 Gew.-% 4-Phenylazodiphenylamin,
6,57 Gew.-% einer Pigmentdispersion,
74,08 Gew.-% Propylenglykolmonomethylether und
10,08 Gew.-% Butyrolacton.

Die beschichtete und getrocknete Platte wird mittels aktinischer Strahlung durch eine Negativ-Testvorlage so belichtet, daß auf einem 21-Stufen-Stauffer-Keil eine vollgedeckte Stufe 7 erhalten wird.

Die Platte läßt sich mit Leitungswasser vollständig entwickeln und desensibilisieren. Anschließend wird mit dem in Beispiel 11 beschriebenen Gemisch konserviert. Im Druckversuch unter den Bedingungen von Beispiel 11 ergibt die Platte 95.000 gute Drucke.

Diese Beispiele verdeutlichen, daß mit erfindungsgemäß hergestellten Druckplatten deutlich erhöhte Druckauflagen erzielt werden können, wobei eine Entwicklung mit Entwicklern möglich ist, die nicht unbedingt organische Lösemittel und nur geringe Mengen an Salzen und Netzmitteln enthalten müssen.

Beispiel 16

Eine nach den Angaben von Beispiel 11 ausgewählte und vorbehandelte Aluminiumplatte wird mit einer Lösung der folgenden Zusammensetzung schleuderbeschichtet:
4,54 Gew.-% des in Beispiel 1 beschriebenen Bindemittels,
2,01 Gew.-% Dipentaerythritmonohydroxypentaacrylat,
2,01 Gew.-% des unten angegebenen diacrylierten Urethanoligomeren,
1,22 Gew.-% des Polykondensationsprodukts aus Beispiel 11,

0,32 Gew.-% 2-Stilbenyl-4,6-bis-(trichlormethyl)-triazin und
89,90 Gew.-% Ethylenglykolmonomethylether.

Das diacrylierte Urethanoligomere wird erhalten durch Umsetzen von 1,6-Hexandiol und Adipinsäure zu einem Polyester, wobei das Molverhältnis größer als 1:1 ist, und anschließendes Umsetzen des Polyesters mit Dicyclohexylmethan-4,4'diisocyanat, wobei das Molverhältnis von Diisocyanat zu Polyester 2:1 beträgt. Das entstandene Produkt wird mit 2-Hydroxyethylacrylat umgesetzt, wobei das Molverhältnis von Acrylat zu Diisocyanat-Polyester-Produkt 2:1 beträgt.

Die beschichtete und getrocknete Platte wird mittels aktinischer Strahlung durch eine Negativ-Testvorlage so belichtet, daß auf einem 21-Stufen-Stauffer-Keil eine vollgedeckte Stufe 7 erhalten wird, und nach den Angaben von Beispiel 11 entwickelt und konserviert. Unter den Bedingungen von Beispiel 11 ergibt die Platte 595.000 gute Drucke.

Beispiel 17

Eine Flachdruckplatte wird nach den Angaben von Beispiel 16 hergestellt und verarbeitet mit der Ausnahme, daß das diacrylierte Urethanoligomere weggelassen wird. Die so hergestellte Platte liefert 315.000 gute Drucke.

Beispiel 18

Eine Flachdruckplatte wird nach den Angaben von Beispiel 16 hergestellt und verarbeitet mit der Ausnahme, daß das Dipentaerythritmonohydroxypentaacrylat weggelassen wird. Die so hergestellte Platte liefert 340.000 gute Drucke.

Beispiel 19

Eine Flachdruckplatte wird nach den Angaben von Beispiel 16 hergestellt und verarbeitet mit der Ausnahme, daß die Diazoverbindung weggelassen wird. Die so hergestellte Platte liefert lediglich 220.000 gute Drucke.

Beispiel 20

Eine Flachdruckplatte wird nach den Angaben von Beispiel 16 hergestellt und verarbeitet mit der Ausnahme, daß das 2-Stilbenyl-4, 6-bis (trichlormethyl)-triazin weggelassen wird. Die so hergestellte Platte liefert 335.000 gute Drucke.

Es ist klar ersichtlich, daß erfindungsgemäß hergestellte Druckplatten hohe Druckauflagen ergeben und mit Gemischen entwickelt werden können, die frei sind von organischen Lösemitteln.

Beispiel 21

Eine nach den Angaben von Beispiel 11 ausgewählte und vorbehandelte Aluminiumplatte wird mit einer Lösung der folgenden Zusammensetzung schleuderbeschichtet:
4,54 Gew.-% des in Beispiel 9 beschriebenen Bindemittels,
2,01 Gew.-% Pentaerythrittetraacrylat,
2,01 Gew.-% des diacrylierten Urethanoligomeren aus Beispiel 16,
1,22 Gew.-% des Polykondensationsprodukts aus Beispiel 11.
0,32 Gew.-% 2-Stilbenyl-4,6-bis-(trichlormethyl)-triazin und
89,90 Gew.-% Ethylenglykolmonomethylether.

Die beschichtete und getrocknete Platte wird mittels aktinischer Strahlung durch eine Negativ-Testvorlage so belichtet, daß auf einem 21-Stufen-Stauffer-Keil eine vollgedeckte Stufe 7 erhalten wird, und nach den Angaben von Beispiel 11 entwickelt und konserviert. Unter den Bedingungen von Beispiel 11 werden 605.000 gute Drucke erhalten.

Beispiel 22

Eine nach den Angaben von Beispiel 11 ausgewählte und vorbehandelte Aluminiumplatte wird mit einer Lösung der folgenden Zusammensetzung schleuderbeschichtet:
4,54 Gew.-% des in Beispiel 8 beschriebenen Bindemittels,
2,01 Gew.-% Pentaerythrittetraacrylat,
2,01 Gew.-% des diacrylierten Urethanoligomeren aus Beispiel 16
1,22 Gew.-% des Polykondensationsprodukts aus Beispiel 11,
0,32 Gew.-% 2-Stilbenyl-4,6-bis-(trichlormethyl)-triazin und
89,90 Gew.-% Ethylenglykolmonomethylether.

Die beschichtete und getrocknete Platte wird mittels aktinischer Strahlung durch eine negative Testvorlage so belichtet, daß auf einem 21-Stufen-Stauffer-Keil eine vollgedeckte Stufe 7 erhalten wird, und

nach den Angaben von Beispiel 11 entwickelt und konserviert. Unter den Bedingungen von Beispiel 11 ergibt die Platte 515.000 gute Drucke.

Beispiel 23 (Vergleichsbeispiel)

Eine nach den Angaben von Beispiel 11 ausgewählte und vorbehandelte Aluminiumplatte wird mit einer Lösung der folgenden Zusammensetzung schleuderbeschichtet:
4,54 Gew.-% des Bindemittels Formvar 12/85 (vgl. Beispiel 5),
2,01 Gew.-% Pentaerythrittetraacrylat,
2,01 Gew.-% des diacrylierten Urethanoligomeren aus Beispiel 16,
1,22 Gew.-% des Polykondensationsprodukts aus Beispiel 11,
0,32 Gew.-% 2-Stilbenyl-4,6-bis-(trichlormethyl)-triazin und
89,90 Gew.-% Ethylenglykolmonomethylether
Die beschichtete und getrocknete Platte wird mittels aktinischer Strahlung durch eine Negativ-Testvorlage so belichtet, daß auf einem 21-Stufen-Stauffer-Keil eine vollgedeckte Stufe 7 erhalten wird; anschließend wird versucht, sie nach den Angaben von Beispiel 11 zu entwickeln. Dabei stellt sich heraus, daß sich die Platte nicht entwickeln läßt. Keinerlei Anzeichen von Entschichtung oder Desensibilisierung können festgestellt werden.

Beispiel 24

Eine nach den Angaben von Beispiel 11 ausgewählte und vorbehandelte Aluminiumplatte wird mit einer Lösung der folgenden Zusammensetzung schleuderbeschichtet:
4,54 Gew.-% des in Beispiel 1 beschriebenen Bindemittels,
2,85 Gew.-% Pentaerythrittetraacrylat,
0,86 Gew.-% Pentaerythrittriacrylat,
0,19 Gew.-% Pentaerythritdiacrylat,
0,12 Gew.-% Pentaerythritacrylat,
1,22 Gew.-% des Polykondensationsprodukts aus Beispiel 11,
0,32 Gew.-% 2-Stilbenyl-4,6-bis-(trichlormethyl)-triazin,
Rest Ethylenglykolmonomethylether.
Die beschichtete und getrocknete Platte wird mittels aktinischer Strahlung durch eine Negativ-Testvorlage so belichtet, daß auf einem 21-Stufen-Stauffer-Keil eine vollgedeckte Stufe 7 erhalten wird, und nach den Angaben von Beispiel 11 entwickelt und konserviert. Unter den Bedingungen von Beispiel 11 ergibt die Platte 540.000 gute Drucke.

Beispiel 25

Eine Flachdruckplatte wird nach den Angaben von Beispiel 24 hergestellt und verarbeitet mit der Ausnahme, daß das Pentaerythritacrylat weggelassen wird. Die so hergestellte Platte liefert 315.000 gute Drucke.

Beispiel 26

Eine Flachdruckplatte wird nach den Angaben von Beispiel 24 hergestellt und verarbeitet mit der Ausnahme, daß das 2-Stilbenyl-4,6-bis-(trichlormethyl)triazin weggelassen wird. Die so hergestellte Platte liefert 335.000 gute Drucke.

Beispiel 27

Eine nach den Angaben von Beispiel 11 ausgewählte und vorbehandelte Aluminiumplatte wird mit einer Lösung der folgenden Zusammensetzung schleuderbeschichtet:
4,54 Gew.-% des in Beispiel 8 beschriebenen Bindemittels,
2,85 Gew.-% Pentaerythrittetraacrylat,
0,86 Gew.-% Pentaerythrittriacrylat,
0,19 Gew.-% Pentaerythritdiacrylat,
0,12 Gew.-% Pentaerythritacrylat,
1,22 Gew.-% des Polykondensationsprodukts aus Beispiel 11,
0,32 Gew.-% 2-Stilbenyl-4,6-bis-(trichlormethyl)-triazin,
Rest Ethylenglykolmonomethylether.
Die beschichtete und getrocknete Platte wird mittels aktinischer Strahlung durch eine negative Testvorlage so belichtet, daß auf einem 21-Stufen-Stauffer-Keil eine vollgedeckte Stufe 7 erhalten wird, und nach den Angaben von Beispiel 11 entwickelt und konserviert. Unter den Bedingungen von Beispiel 11 ergibt die Platte 510.000 gute Drucke.

Beispiel 28

Eine nach den Angaben von Beispiel 11 ausgewählte und vorbehandelte Aluminiumplatte wird mit einer Lösung der folgenden Zusammensetzung schleuderbeschichtet:
4,54 Gew.-% des in Beispiel 9 beschriebenen Bindemittels,
2,85 Gew.-% Pentaerythrittetraacrylat,
0,86 Gew.-% Pentaerythrittriacrylat,
0,19 Gew.-% Pentaerythritdiacrylat,
0,12 Gew.-% Pentaerythritacrylat,
1,22 Gew.-% des Polykondensationsprodukts aus Beispiel 11.
0,32 Gew.-% 2-Stilbenyl-4,6-bis-(trichlormethyl)-triazin,
Rest Ethylenglykolmonomethylether

Die beschichtete und getrocknete Platte wird mittels aktinischer Strahlung durch eine Negativ-Testvorlage so belichtet, daß auf einem 21-Stufen-Stauffer-Keil eine vollgedeckte Stufe 7 erhalten wird, und nach den Angaben von Beispiel 11 entwickelt und konserviert. Unter den Bedingungen von Beispiel 11 werden 575.000 gute Drucke erhalten.

**Patentansprüche**

1. Polymeres aus Einheiten der allgemeinen Typen A, B und C, wobei A in einem Mengenanteil von 5 bis 20 Gew.-% vorliegt und der Formel

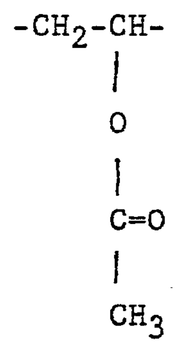

entspricht, B in einem Mengenanteil von 4 bis 30 Gew.-% vorliegt und der Formel

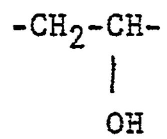

entspricht und C in einem Mengenanteil von 50 bis 91 Gew.-% vorliegt, dadurch gekennzeichnet, daß die Einheiten C aus Einheiten der Formel C I, C II und C III

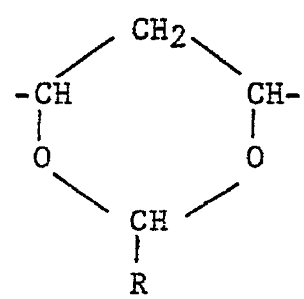

(C I),

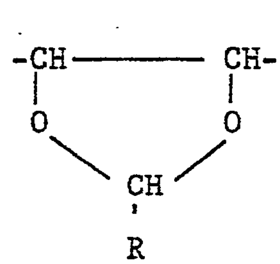

(C II),

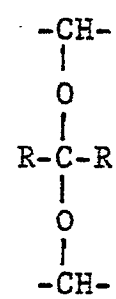

(C III)

bestehen, worin

R ein Wasserstoffatom oder ein gesättigter gerad- oder verzweigkettiger Kohlenwasserstoffrest mit 1 bis 8 Kohlenstoffatomen ist
und worin die Einheiten C I in einem Anteil von 75 bis 85 Gew.-%, die Einheiten C II in einem Anteil von 3 bis 5 Gew.-% und die Einheiten C III in einem Anteil von 10 bis 22 Gew.-%, bezogen auf das Gesamtgewicht der Einheiten C, vorliegen.

2. Polymeres nach Anspruch 1, dadurch gekennzeichnet, daß es ein Molekulargewicht von 5.000 bis 100.000 hat.

3. Verfahren zur Herstellung des Polymeren gemäß Anspruch 1, dadurch gekennzeichnet, daß man
a) ein Vinylalkohol/Vinylacetat-Copolymeres mit einem Gehalt von 75 bis 80 Gew.-% Vinylalkoholeinheiten in einem Gemisch von Wasser und einem Hydroxylgruppen enthaltenden organischen Lösemittel auflöst,
b) die Lösung auf eine Temperatur zwischen 50° C und ihrem Siedepunkt erwärmt und eine katalytische Menge einer organischen Sulfonsäure oder einer Mineralsäure zusetzt und
c) einen niederen aliphatischen Aldehyd in solcher Menge zusetzt, daß 50 bis 91 Gew.-% der Hydroxylgruppen acetalisiert werden.

4. Lichtempfindliches Gemisch, das ein Polymeres gemäß Anspruch 1 und ein Diazoniumsalz-Polykondensationsprodukt enthält.

5. Lichtempfindliches Gemisch nach Anspruch 4, dadurch gekennzeichnet, daß das Diazoniumsalz-Polykondensationsprodukt durch Umsetzen mindestens einer Verbindung der Formel $A\text{-}N_2X$ mit mindestens einer Verbindung $B_1$ der Formel

$$E(-CHR_a-OR_b)_m$$

wobei A der Rest einer Verbindung der Formel

$$(R_1-R_3-)_pR_2-N_2X$$

ist, worin
$R_1$ eine unsubstituierte oder substituierte Phenyl- oder Naphthylgruppe,
$R_2$ eine unsubstituierte oder substituierte Phenylengruppe,
$R_3$ eine Einfachbindung oder eine der Gruppen

$-(CH_2)_q-NR_4-$,
$-O-(CH_2)_r-NR_4-$,
$-S-(CH_2)_r-NR_4-$,
$-S-CH_2-CO-NR_4-$,
$-O-R_5-O-$,
$-O-$,
$-S-$ oder
$-CO-NR_4-$

ist, wobei
q eine Zahl von 0 bis 5,
r eine Zahl von 2 bis 5,
$R_4$ Wasserstoff, eine Alkylgruppe mit 1 bis 5 Kohlenstoffatomen, eine Aralkylgruppe mit 7 bis 12 Kohlenstoffatomen oder eine Arylgruppe mit 6 bis 12 Kohlenstoffatomen,
$R_5$ eine Arylengruppe mit 6 bis 12 Kohlenstoffatomen,
X das Anion des Diazoniumsalzes,
p eine Zahl von 1 bis 3,
E der durch Abspalten von m Wasserstoffatomen aus einem von Diazoniumgruppen freien aromatischen Amin, Phenol, Thiophenol, Phenolether, aromatischen Thioether, einer aromatischen heterocyclischen Verbindung, einem aromatischen Kohlenwasserstoff oder einem organischen Säureamid entstandene Rest,
$R_a$ ein Wasserstoffatom oder eine Phenylgruppe,
$R_b$ ein Wasserstoffatom, eine niedere Alkyl-, Acyl- oder eine Phenylgruppe und
m eine Zahl von 1 bis 10 ist,
in einem stark sauren Medium unter solchen Bedingungen hergestellt worden ist, daß das Kondensationsprodukt im Mittel 0,1 bis 50 Einheiten $B_1$ je Einheit $A\text{-}N_2X$ enthält.

6. Lichtempfindliches Gemisch nach Anspruch 5, dadurch gekennzeichnet, daß es zusätzlich einen Photoinitiator und eine radikalisch polymerisierbare Verbindung enthält.

7. Lichtempfindliches Gemisch nach Anspruch 6, dadurch gekennzeichnet, daß die radikalisch polymerisierbare Verbindung ein Gemisch aus
a) einem Acryl- oder Methacrylsäureester mit zwei oder mehreren ungesättigten Gruppen und
b) einem Oligomeren ist, das durch Umsetzen von 1 mol einer linearen polymeren Verbindung mit einem aktiven Wasserstoffatom an jedem Ende mit mindestens 2 mol eines Diisocyanats und Umsetzen des Reaktionsprodukts mit mindestens 2 mol einer ethylenisch ungesättigten Verbindung, die ein aktives Wasserstoffatom enthält, hergestellt worden ist.

8. Lichtempfindliches Gemisch nach Anspruch 6, dadurch gekennzeichnet, daß die radikalisch polymerisierbare Verbindung eine Verbindung mit mindestens zwei ethylenisch ungesättigten Gruppen ist.

9. Lichtempfindliches Gemisch nach Anspruch 6, dadurch gekennzeichnet, daß die radikalisch polymerisierbare Verbindung ein Gemisch aus einem Acryl- oder Methacrylsäureester mit mindestens zwei ungesättigten Gruppen und einem Acryl- oder Methacrylsäureester mit einer ungesättigten Gruppe ist.

**Claims**

1. Polymer containing units of the general types A, B and C, in which a is present in a relative amount of 5 to 20% by weight and has the formula

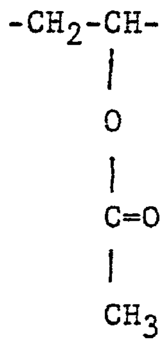

B is present in a relative amount of 4 to 30% by weight and has the formula

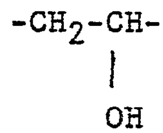

and C is present in a relative amount of 50 to 90% by weight, characterized in that the units C are composed of units of the formula C I, C II and C III

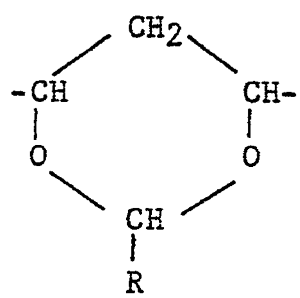

(C I),

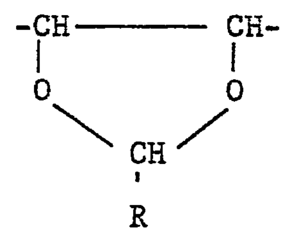

(C II),

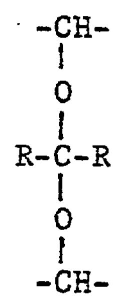

(C III)

in which
R is a hydrogen atom or saturated straight-chain or branched hydrocarbon radical of 1 to 8 carbon atoms and in which the units C I are present in a relative amount of 75 to 85% by weight, the units C II in a relative amount of 3 to 5% by weight and the units C III in a relative amount of 10 to 22% by weight, relative to the total weight of the units C.

2. Polymer according to Claim 1, characterized in that it has a molecular weight of 5,000 to 100,000.

3. Process for the preparation of the polymer according to Claim 1, characterized in that

a) a vinyl alcohol/vinyl acetate copolymer containing 75 to 80% by weight of vinyl alcohol units is dissolved in a mixture of water and a hydroxyl-containing organic solvent,

b) the solution is heated to a temperature between 50°C and its boiling point and a catalytic amount of organic sulfonic acid or a mineral acid is added and

c) a lower aliphatic aldehyde is added in such an amount that 50 to 91% by weight of the hydroxyl groups are acetalized.

4. Light-sensitive mixture containing a polymer according to Claim 1 and a diazonium salt polycondensation product.

5. Light-sensitive mixture according to Claim 4, characterized in that the diazonium salt polycondensation product has been prepared by reacting at least one compound of the formula $A{-}N_2X$ with at least one compound $B_1$ of the formula

$$E(-CHR_a-OR_b)_m$$

in which A is a radical of the compound of the formula

$$(R_1-R_3-)_pR_2-N_2X$$

in which

$R_1$ is a substituted or unsubstituted phenyl naphthyl group,

$R_2$ is a substituted or unsubstituted phenylene group,

$R_3$ is a single bond or one of the groups

$-CH_2)_q-NR_4-$,
$-O-(CH_2)_r-NR_4-$,
$-S-(CH_2)_r-NR_4-$,
$-S-CH_2-CO-NR_4-$,
$-O-R_5-O-$,
$-O-$,
$-S-$ or
$-CO-NR_4-$

in which

q is a number from 0 to 5,

r is a number from 2 to 5,

$R_4$ is hydrogen, an alkyl group of 1 to 5 carbon atoms, an aralkyl group of 7 to 12 carbon atoms or an aryl group of 6 to 12 carbon atoms,

$R_5$ is an arylene group of 6 to 12 carbon atoms,

X is the anion of the diazonium salt,

p is a number from 1 to 3,

E is the radical formed by elimination of m hydrogen atoms from a diazonium-free aromatic amine, phenol, thiophenol, phenol ether, aromatic thio ether, aromatic heterocyclic compound, aromatic hydrocarbon or organic amide,

$R_a$ is a hydrogen atom or a phenyl group,

$R_b$ is a hydrogen atom, a lower alkyl, acyl or a phenyl group and

m is a number from 1 to 10,

in a strongly acidic medium under such conditions that the condensation product contains on average 0.1 to 50 $B_1$ units per $A{-}N_2X$ unit.

6. Light-sensitive mixture according to Claim 5, characterized in that it additionally contains a photoinitiator and a compound polymerizable by free radicals.

7. Light-sensitive mixture according to Claim 6, characterized in that the compound polymerizable by free radicals is a mixture composed of

a) an acrylic or methacrylic ester containing two or several unsaturated groups and

b) an oligomer which has been prepared by reaction of 1 mol of a linear polymeric compound containing an active hydrogen atom at each end with at least 2 mol of a diisocyanate and reaction of the reaction product with at least 2 mol of an ethylenically unsaturated compound which contains an active hydrogen atom.

8. Light-sensitive mixture according to Claim 6, characterized in that the compound polymerizable by free radicals is a compound containing at least two ethylenically unsaturated groups.

9. Light-sensitive mixture according to Claim 6, characterized in that the compound polymerizable by free radicals is a mixture of an acrylic or methacrylic ester containing at least two unsaturated groups and an acrylic or methacrylic ester containing one unsaturated group.

## Revendications

1. Polymère constitué de motifs des types généraux A, B et C, A étant présent en une proportion de 5 à 20% en poids et correspondant à la formule

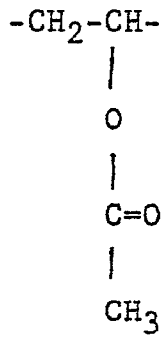

B étant présent en une proportion de 4 à 30% en poids et correspondant à la formule

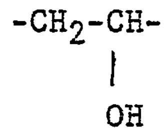

et C étant présent en une proportion de 50 à 91% en poids, caractérisé en ce que les motifs C consistent en des motifs de formule C I, C II et C III

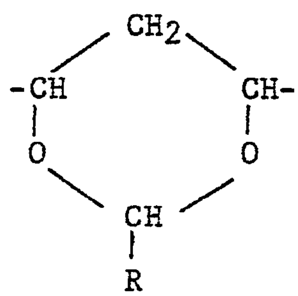

(C I),

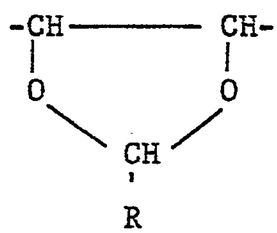

(C II),

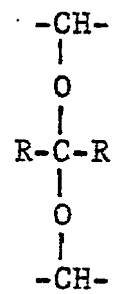

(C III)

dans lesquelles
R est un atome d'hydrogène ou un radical hydrocarboné saturé à chaîne droite ou ramifiée, ayant de 1 à 8 atomes de carbone,
et les motifs C I étant présents en une proportion de 75 à 85% en poids, les motifs C II étant présents en une proportion de 3 à 5% en poids et les motifs C III étant présents en une proportion de 10 à 22% en poids, par rapport au poids total des motifs C.

2. Polymère selon la revendication 1, caractérisé en ce qu'il a une masse moléculaire de 5 000 à 100 000.

3. Procédé pour la préparation du polymère selon la revendication 1, caractérisé en ce que
a) on dissout un copolymère alcool vinylique/acétate de vinyle, ayant une teneur de 75 à 80% en poids en motifs alcool vinylique, dans un mélange d'eau et d'un solvant organique contenant des groupes hydroxy,
b) on chauffe la solution à une température comprise entre 50°C et son point d'ébullition, et on ajoute une quantité catalytique d'un acide sulfonique organique ou d'un acide minéral, et
c) on ajoute un aldéhyde aliphatique inférieur, en une quantité telle que 50 à 91% en poids des groupes hydroxy sont transformés en acétals.

4. Composition photosensible contenant un polymère selon la revendication 1 et un produit de polycondensation de sel en diazonium.

5. Composition photosensible selon la revendication 4, caractérisé en ce que le produit de polycondensation de sel de diazonium a été préparé par réaction d'au moins un composé du type $A-N_2X$ avec au moins un composé du type $B_1$ de formule

$$E(-CHR_a-OR_b)_m$$

A représentant le reste d'un composé de formule

$$(R_1-R_3-)_pR_2-N_2X$$

dans laquelle
$R_1$ est un groupe phényle ou naphtyle substitué ou non substitué,
$R_2$ est un groupe phénylène substitué ou non substitué,
$R_3$ est une simple liaison ou l'un des groupes

$$-(CH_2)_q-NR_4-,$$
$$-O-(CH_2)_r-NR_4-,$$
$$-S-(CH_2)_r-NR_4-,$$
$$-S-CH_2-CO-NR_4-,$$
$$-O-R_5-O-,$$
$$-O-,$$
$$-S-\text{ ou}$$
$$-CO-NR_4-,$$

q étant un nombre allant de 0 à 5,
r étant un nombre allant de 2 à 5,
$R_4$ étant un atome d'hydrogène ou un groupe alkyle ayant de 1 à 5 atomes de carbone, un groupe aralkyle ayant de 7 à 12 atomes carbone ou un groupe aryle ayant de 6 à 12 atomes de carbone,
$R_5$ étant un groupe arylène ayant de 6 à 12 atomes de carbone,
X étant l'anion du sel de diazonium,
p étant un nombre allant de 1 à 3,
E étant le reste résultant de l'élimination de m atomes d'hydrogène hors d'une amine aromatique exempte de groupe diazonium, d'un phénol, thiophénol, éther phénylique, thioéther aromatique, d'un composé hétérocyclique aromatique, d'un hydrocarbure aromatique ou d'un amide organique,
$R_a$ étant un atome d'hydrogène ou un groupe phényle,
$R_b$ étant un atome d'hydrogène, un groupe alkyle inférieur, acyle ou phényle, et
m étant un nombre allant de 1 à 10,
dans un milieu fortement acide, dans des conditions telles que le produit de condensation contient en moyenne de 0,1 à 50 motifs $B_1$ par motif $A-N_2X$.

6. Composition photosensible selon la revendication 5, caractérisée en ce qu'elle contient en outre un photo-initiateur et un composé polymérisable par polymérisation radicalaire.

7. Composition photosensible selon la revendication 6, caractérisée en ce que le composé polymérisable par polymérisation radicalaire est un mélange de
a) un ester d'acide acrylique ou méthacrylique comportant deux groupes insaturés ou plus, et
b) d'un oligomère qui a été préparé par réaction de 1 mole d'un composé polymère linéaire comportant un atome d'hydrogène actif à chaque extrémité, avec au moins 2 moles d'un diisocyanate, et réaction du produit de réaction avec au moins 2 moles d'un composé à insaturation éthylénique, contenant un atome d'hydrogène actif.

8. Composition photosensible selon la revendication 6, caractérisée en ce que le composé polymérisable par polymérisation radicalaire est un composé comportant au moins deux groupes à insaturation éthylénique.

9. Composition photosensible selon la revendication 6, caractérisée en ce que le composé polymérisable par polymérisation radicalaire est un mélange d'un ester d'acide acrylique ou méthacrylique, comportant au moins deux groupes insaturés, et d'un ester d'acide acrylique ou méthacrylique comportant un groupe insaturé.